Europäisches Patentamt

(19) European Patent Office

Office européen des brevets

(11) Publication number: **0 029 857**
**B1**

(12) **EUROPEAN PATENT SPECIFICATION**

(45) Date of publication of patent specification: **29.08.84**

(51) Int. Cl.³: **H 01 L 21/30, G 11 C 11/14**

(21) Application number: **80901043.2**

(22) Date of filing: **06.06.80**

(86) International application number:
**PCT/JP80/00125**

(87) International publication number:
**WO 80/02772 11.12.80 Gazette 80/28**

(54) **ELECTRON BEAM PROJECTING SYSTEM.**

(30) Priority: **08.06.79 JP 72088/79**
**08.06.79 JP 72087/79**
**12.06.79 JP 73811/79**
**22.01.80 JP 6026/80**

(43) Date of publication of application:
**10.06.81 Bulletin 81/23**

(45) Publication of the grant of the patent:
**29.08.84 Bulletin 84/35**

(84) Designated Contracting States:
**DE FR GB NL**

(56) References cited:
**JP-A-54 025 675**
**JP-A-54 072 683**
**US-A-3 914 608**
**US-A-4 147 937**

**Electronics/May 12, 1977, H.P. Chang, etal**
**"Electron-beam Lithography draws a finer line"**
**P. 89-98, Fig 5**

(73) Proprietor: **FUJITSU LIMITED**
**1015, Kamikodanaka Nakahara-ku**
**Kawasaki-shi Kanagawa 211 (JP)**

(72) Inventor: **IGAKI, Seigo**
**474-59-103, Hirao Inagi-shi**
**Tokyo 192-02 (JP)**
Inventor: **GOTO, Yoshiro**
**3-6-106, Susukinodanchi Midori-ku**
**Yokohama-shi Kanagawa 227 (JP)**
Inventor: **FURUKAWA, Yasuo**
**447-19, Oshidate Inagi-shi**
**Tokyo 192-02 (JP)**

(74) Representative: **Rackham, Stephen Neil et al**
**GILL JENNINGS & EVERY 53-64 Chancery Lane**
**London WC2A 1HN (GB)**

(56) References cited:
**THE JOURNAL OF VACUUM SCIENCE AND
TECHNOLOGY, vol. 12, no. 6,
November/december 1975, pages 1246-1250
New York, U.S.A. F.S. OZDEMIR et al.: "A
pattern generation technique for serial
electron-beam microfabrication systems"**

# Description

## Technical field

The present invention relates to an exposure system using an electron beam. The exposure using an electron beam contemplated by the present invention can be employed for forming patterns in an electronic memory device such as magnetic bubble device by irradiating the electron beam.

## Background art

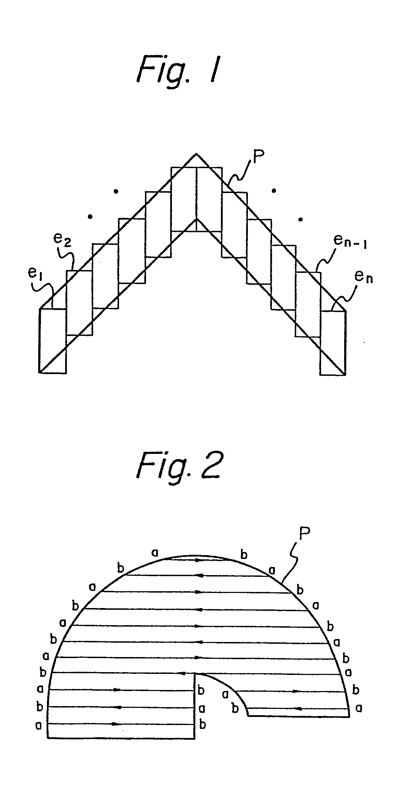

In effecting the exposure using the irradiation of an electron beam to form a chevron figure in a magnetic bubble memory device, it is accepted practice to approximate the chevron figure P by many rectangular picture elements $e_1, e_2, \ldots e_n$ as shown in Fig. 1, to store the data of the individual rectangular picture elements in a main memory, and to successively read the data from the main memory to supply irradiation instructions to a device for irradiating the electron beam. This method requires a digital-to-analog converter for converting the digital data of each of the rectangular picture elements into irradiation instruction signals of analog quantities.

However, since there exist a great number of rectangular picture elements, the above-mentioned conventional method presented a problem with regard to enormous amounts of data that must be transferred from the main memory to the device for irradiating the electron beam responsive to the instruction of the central processor, as well as a problem with regard to the difficulty in increasing the operation speed since considerably great settling times were necessary for the digital-to-analog converter. When the magnetic bubble memory device employs a figure of the type of a chevron set in which a great number of chevron figures of the same pattern are arrayed, as well as a digital-to-analog converter consisting of a digital-to-analog converter for start-point data which determines the starting point of each rectangular picture element of each chevron figure and a digital-to-analog converter for data for scanning each rectangular picture element of each chevron figure, the start-point of the rectangular picture elements of the chevron figures must be determined many times. Namely, the digital-to-analog converter needs longer setting times.

Fig. 2 illustrates another conventional exposure system using an electron beam. According to this method, a desired figure P is successively scanned along the horizontal lines, and a start point a and an end point b are specified for each line. Even in this system which has many startpoints, the digital-to-analog converter requires an increased setting time for each of the start-points, and makes it difficult to increase the operation speed. This system has been disclosed, for example, in A. M. Patlach et al. Electron-beam Lithographic Pattern Generation System, J. Vac. Sci. Technol. 15(3), American Vacuum Society, May/June, 1978.

The present invention is proposed to solve the above-mentioned problems inherent in the conventional exposure systems using an electron beam. From US—A—4 147 937 there is known an exposure system using an electron beam comprising:

an electron beam blanking means;
a scanning electron beam deflector means;
a pattern generation control circuit; and,
a pattern package memory;

the pattern generation control circuit storing data on the size of a pattern to be irradiated by the electron beam, the pattern package memory storing data giving instructions for when the beam is to be blanked, and a signal for blanking the electron beam being supplied to the electron beam blanking means from the pattern package memory. From Electronics, May 12, 1977, p. 89—98 it is known that the electron beam scans the entire area of the chip while blanking is performed to generate the pattern.

## Disclosure of the invention

In exposing a figure of a particular shape different from a rectangular shape using the electron beam, the principal object of the present invention is to increase the operation speed of the exposure by using an electron beam, by reducing the quantity of data for forming figures, reducing the time for transferring the data, and reducing the settling time of the digital-to-analog converter which is required for setting start-points.

According to the present invention, there is provided an exposure system using an electron beam, comprising:

an electron beam blanking means;
a scanning electron beam deflector means;
a pattern generation control circuit; and,
a pattern package memory;

the pattern generation control circuit storing data on the location and size of a simple surrounding figure which surrounds a pattern to be irradiated by the electron beam, the pattern package memory storing data giving instructions for when the beam is to be blanked whilst being scanned over the surrounding figure to generate said pattern to be irradiated, a signal for scanning the entire area of the surrounding figure based on the location and size data being supplied to the scanning electron beam deflector means from the pattern generation control circuit, and a signal for blanking the electron beam being supplied to the electron beam blanking means from the pattern package memory.

## Brief description of the drawings

Figs. 1 and 2 are diagrams to illustrate the conventional exposure systems using an electron beam;

Figs. 3 and 4 are diagrams of a pattern to which is applied the exposure system using an electron beam according to an embodiment of the present invention;

Fig. 5 is a circuit diagram of a device employed for the exposure system by electron beam according to the embodiment of the present invention;

Fig. 6 is a diagram illustrating a modified example of the pattern of Fig. 3;

Figs. 7, 8 and 9 are diagrams illustrating modified forms of the pattern of Fig. 3;

Fig. 10A is a diagram illustrating a modified example of the circuit of Fig. 5;

Fig. 10B is a diagram illustrating a signal processing circuit which is employed for the device of Fig. 10A;

Fig. 10C is a diagram illustrating a data series in the circuit of Fig. 10B;

Fig. 11 is a diagram of the pattern for illustrating the operation of the circuit of Fig. 10;

Figs. 12A and 12B are diagrams illustrating another modified example of the circuit of Fig. 5;

Fig. 13 is a diagram of patterns for illustrating the operation of the circuit of Fig. 12; and

Figs. 14 and 15 are diagrams of a digital-to-analog converter circuit for modification of Fig. 12, and a diagram of patterns for modification.

Description of the preferred embodiments

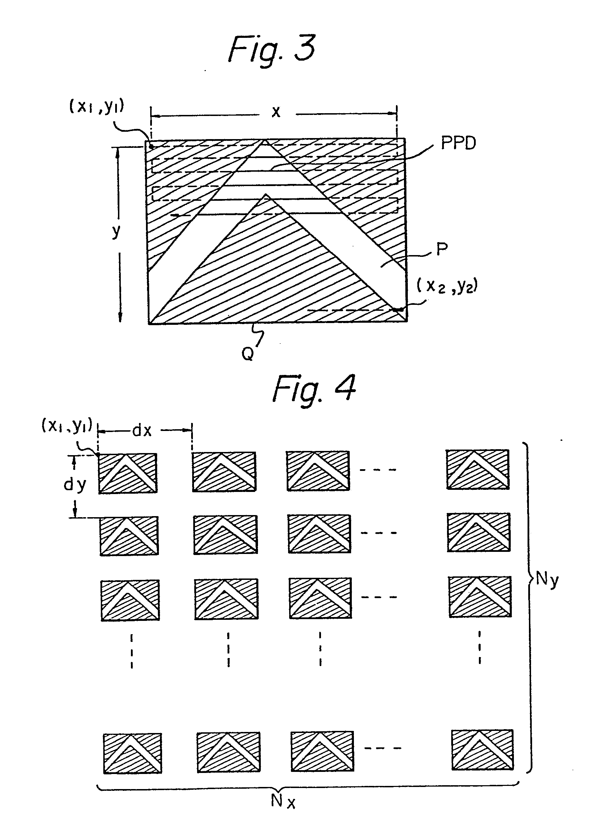

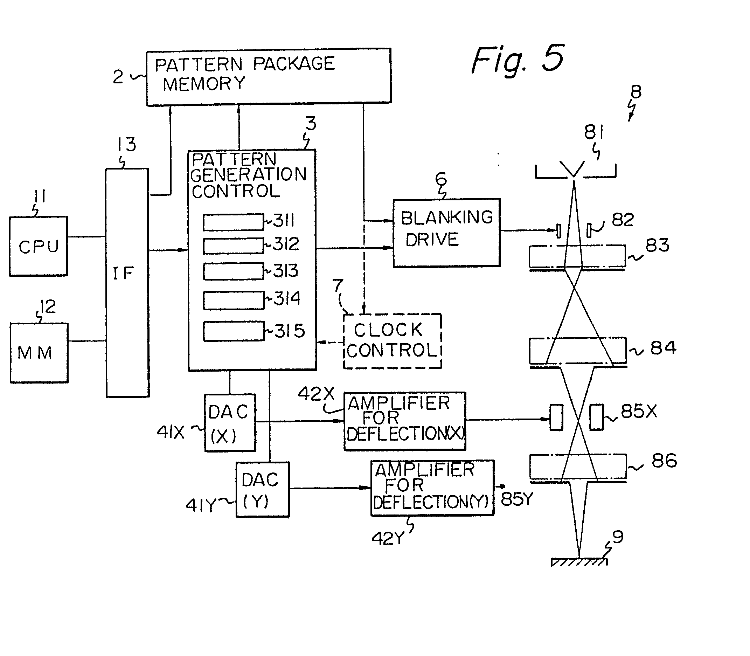

Figs. 3 and 4 illustrate the operation of the exposure system using an electron beam according to an embodiment of the present invention, and Fig. 5 illustrates a device which is employed for the exposure system using an electron beam. In this embodiment, a fundamental pattern P having the shape of a chevron figure is exposed. In this case, the pattern P is surrounded by a figure Q which circumscribes the pattern P and which is more simplified than the pattern P. In Fig. 3, a rectangle is selected as a surrounding figure. To scan the whole region of the surrounding figure Q, the electron beam performs the scanning along a scanning path which starts from a point $(x_1, y_1)$ at the upper left corner and which ends at a point $(x_2, y_2)$ located at the lower right corner. The scanning is effected by a scanning electron beam deflector 85 which is an electron beam deflection means of an electron beam irradiation device 8 in Fig. 5. Further, the electron beam is rendered not to be irradiated when it scans the region other than the pattern P, so that the electron beam irradiates the pattern P only. The electron beam is rendered not to irradiate by a blanking deflector (blanker) 82 which is another electron beam deflection means of the electron beam irradiation device 8 of Fig. 5. While the electron beam is performing the scanning from the point $(x_1, y_1)$ to the point $(x_2, y_2)$, the electron beam is rendered to irradiate i.e., "ON" when it scans within the pattern P, and is rendered not to irradiate i.e., "OFF" when it scans the regions other than the pattern P. The data related to the positions for irradiating the electron beam or for rendering the electron beam "ON" or "OFF", have been stored in a pattern package memory that will be mentioned later. For the sake of convenience, the data related to the positions for an irradiating electron beam is hereinafter referred to as pattern package data. In Fig. 3, the "OFF" state of the pattern package data PPD is indicated by broken lines and the "ON" state is indicated by solid lines. Irradiation of the pattern P of Fig. 3 with the electron beam requires data of a coordinate position $(x_1, y_1)$ at the start-point of the surrounding figure, data for scanning the surrounding figure, and the pattern package data.

When the total pattern array consists of the repetition of a chevron pattern as shown in Fig. 4 the data at the start-points of the surrounding figures of each of the fundamental patterns are necessary. Here, however, only one scanning datum and one pattern package datum will suffice for each surrounding figure.

The device of Fig. 5 operates to expose the pattern P of Figs. 4 and 5 to the electron beam. The electron beam irradiation device 8 of Fig. 5 consists of an electron gun 81, an electron beam blanker 82, electron beam lenses 83, 84, 86, a deflector 85X for X axis, a deflector 85Y (not shown) for Y axis, and a subject 9 to be exposed. A central processor unit 11 and a main memory 12 are connected, via an interface 13, to a pattern package memory 2 and a pattern generation control circuit 3. The output of the pattern generation control circuit is fed to X-axis and Y-axis digital-to-analog converters 41X and 41Y, the outputs of the digital-to-analog converters 41X and 41Y are fed to X-axis and Y-axis deflection amplifiers 42X and 42Y, and the outputs of the X-axis and Y-axis deflection amplifiers are fed to the X-axis deflector 85X and Y-axis deflector 85Y. The data read from the pattern package memory 2 is fed to a blanking drive circuit 6, and the output of the blanking drive circuit is fed to a blanker 82. The pattern generation control circuit 3 receives clock control signals from a clock control circuit 7.

The device shown in Fig. 5 operates as mentioned below. First, the pattern package data stored in the main memory 12 is read by the instruction from the central processor 11, and is written on the pattern package memory 2 passing through the interface 13. The pattern package data is a time-series data for the irradiating or not irradiating state of the electron beam as shown in Fig. 3.

The data $(x_1, y_1)$ related to the start-point of the surrounding figure, the data for electron beam scanning, the data $(d_x, d_y)$ related to a distance between the start-points of fundamental patterns, the data $N_x$ related to the number of fundamental pattern trains, the data $N_y$ related to the number of fundamental pattern rows, and the data for specifying the address of the pattern package, are registered in the register groups 311 to 315 in the pattern generation control circuit 3. Based upon the data registered in these registers 311 to 315, the pattern generation control circuit 3 sends necessary electron beam exposure signals to the digital-to-analog converters 41X and 41Y. The analog output signals from the digital-to-analog converters 41X and 41Y are fed to the deflection amplifiers 42X and 42Y, and the output signals of the deflection amplifiers 42X and 42Y are fed to the electron beam deflectors 85X and 85Y to effect the scanning by electron beam. Only the deflector 85X for X axis is diagrammatized, and the deflector for Y axis is not diagrammatized.

The pattern package data stored in the pattern package memory 2 is read being controlled by the pattern generation control circuit 3, fed to the beam blanking driver 6, and the output signal of the beam blanking driver 6 is fed to the blanker 82 to render the electron beam irradiated or not irradiated. Therefore, a desired pattern P is exposed on the surface of the subject 9 to be exposed due to the combination of the scanning by the deflectors 85X, 85Y and the turn on and off of irradiation.

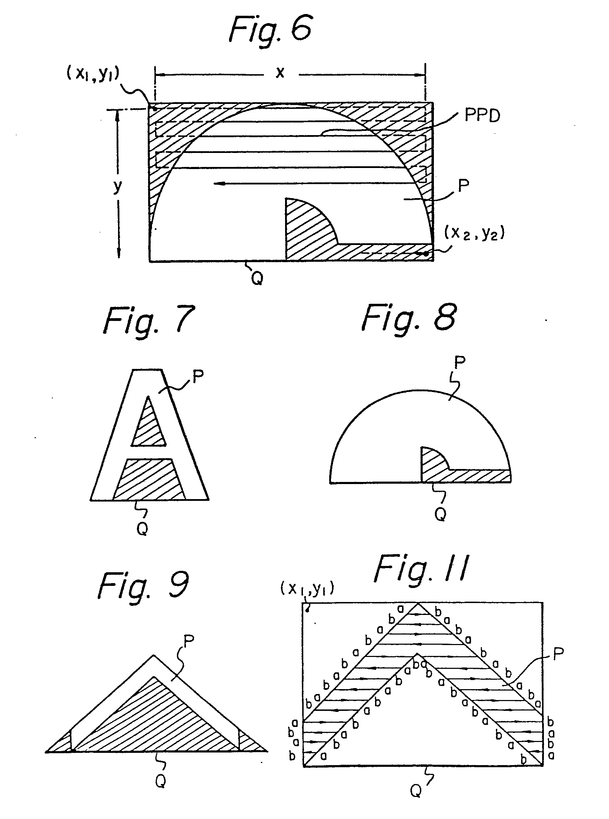

The pattern P needs not be limited to the chevron figure as shown in Fig. 3, but may be applied to any other shapes as illustrated in Fig. 6.

The surrounding figure Q needs not be limited to the rectangular shape only of Figs. 3 and 6, but may have shapes as shown in Figs. 7, 8 and 9. The figures of Figs. 7, 8 and 9 circumscribe a desired pattern, and have been more simplified than the desired pattern. Namely, a trapezoidal shape, a semicircular shape and a triangular shape are used as the surrounding figures.

The direction of scanning lines need not be limited to the horizontal direction only as shown in Fig. 3, but may be tilted at a predetermined angle.

The device of Fig. 5 can further be provided with a clock control circuit 7 which feeds clock signals to the pattern generation control circuit 3, to change the scanning speed of the electron beam in order to further increase the speed of the exposure operation by the electron beam. In this case, the clock control circuit 7 changes the frequency of the clock signals; the clock control circuit 7 produces clock signals of ordinary frequency when the pattern package data is "ON" and produces clock signals of an increased frequency when the pattern package data is "OFF". Therefore, when the pattern package data is "ON", the electron beam performs the scanning at a predetermined speed and is irradiated in amounts sufficient for forming the pattern per unit area in a predetermined region of the specimen where the desired pattern is to be formed. When the pattern package data is "OFF", the electron beam performs the scanning at a speed greater than when the pattern package data is "ON", to reduce the scanning time. Accordingly, the exposure operation by the electron beam can be effected at an increased speed.

In the device of Fig. 5, the digital-to-analog converter circuits 41X and 41Y perform the digital-to-analog conversion of the data related to the start-point of the surrounding figure and the digital-to-analog conversion of the scanning data. However, the same operation can also be performed by providing a digital-to-analog circuit of a relatively low speed having increased number of bits and a digital-to-analog circuit of a relatively high speed having decreased number of bits, performing the digital-to-analog conversion of the data related to the start-point of surrounding figures by the former circuit, performing the digital-to-analog conversion of the scanning data by the latter circuit, adding the two digital-to-analog converted outputs through an adder circuit, and feeding the resulting output to an amplifier for deflection.

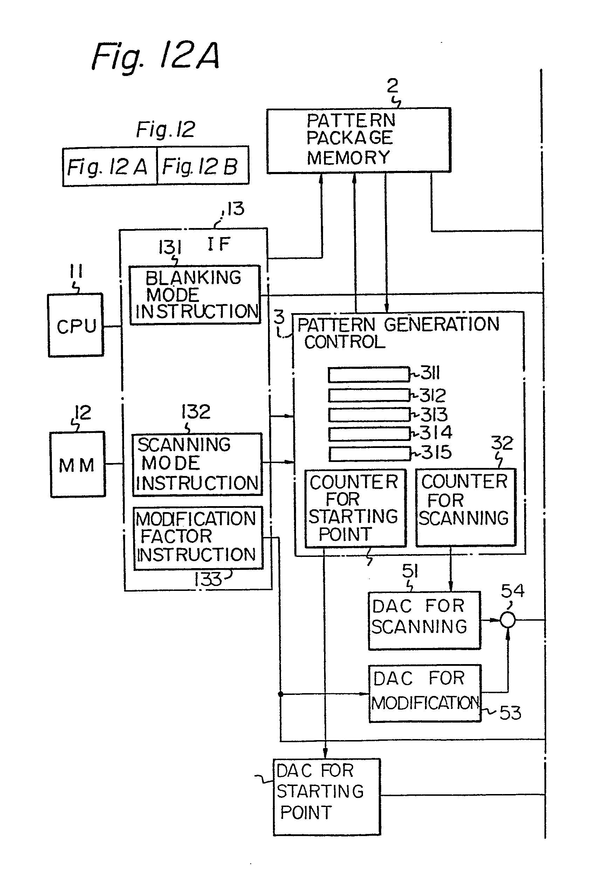

Fig. 10A illustrates a modified example of the device of Fig. 5, and Fig. 11 illustrates the exposure using an electron beam using the device of Fig. 10A. According to the device of Fig. 10A, the electron beam performs the scanning for the pattern portions only of the pattern of Fig. 11, and does not perform the scanning for portions other than the pattern. The scanning is effected between the start-point $a$ of exposure and the end point $b$ of exposure of each scanning line. The scanning which has reached the end point $b$ of a given scanning line moves to the start-point $a$ of the next scanning line. Therefore, the data stored in the pattern package memory 2 of the device of Fig. 10A are related to the coordinate positions of start-points and end points of each of the scanning lines. The data read from the pattern package memory 2 are fed to the blanking driver 6 via the pattern generation control circuit, and are further fed to the digital-to-analog converter circuits 41X, 41Y, 51X and 51Y. The digital-to-analog converter circuits 41X and 41Y perform the digital-to-analog conversion for the data of the contour start-point $(x_1, y_1)$, and the digital-to-analog converter circuits 51X and 51Y perform the digital-to-analog conversion for the data of exposure start-point $a$ and exposure end point $b$. The digital-to-analog converter circuits 51X and 51Y operate at speeds faster than the digital-to-analog converter circuits 41X and 41Y. The digital-to-analog converter circuits 41X, 41Y operate at speeds lower than the digital-to-analog converter circuits 51X, 51Y, but utilize increased number of bits to precisely determine the position of the contour start-point $(x_1, y_1)$. The outputs of the digital-to-analog converter circuits 41X, 41Y and the outputs of the digital-to-analog converter circuits 51X, 51Y are added together through adder circuits 52X, 52Y, and are fed to deflection amplifiers 42X, 42Y. The outputs of the deflection amplifiers 42X, 42Y are fed to deflectors 85X, 85Y. The pattern P of Fig. 11 is exposed to the electron beam owing to the operations of the blanker 82, and deflectors 85X, 85Y.

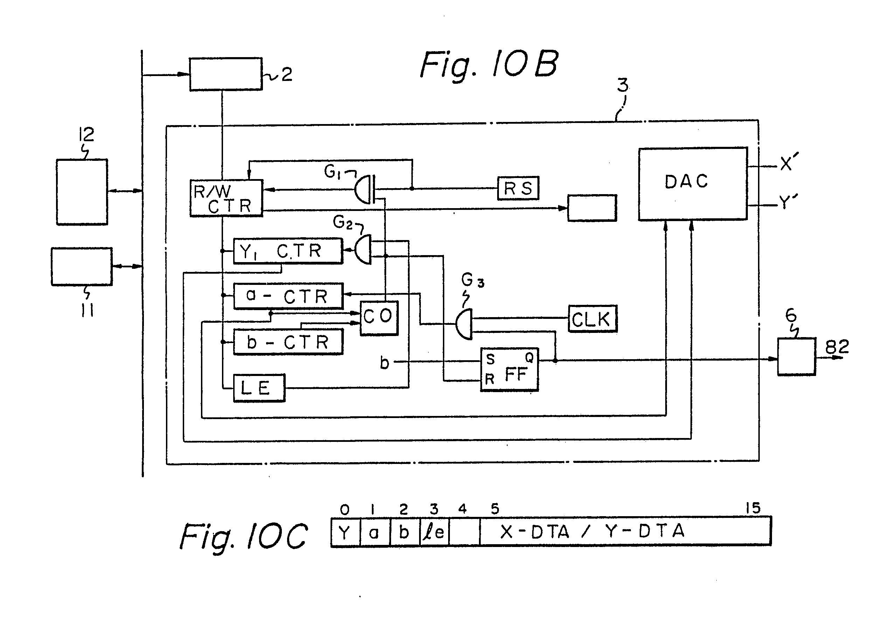

Figs. 10B and 10C illustrate a signal processing circuit which is used for the device of Fig. 10A, and a data series. The beam ON/OFF data shown in Fig. 10C consists of two bytes for one word, wherein five bits from the O-th through the 4th bit constitute a command, and eleven bits from the 5th through the 15th bit constitute an X data or a Y data. The data "1" in the command portion indicates either the $a$(ON) coordinate or the $b$(OFF) coordinate. The data "Y" is used to discretely change the deflection. The data "le" indicates the end of the scanning line.

The line operation initiating signal RS is fed, via an OR gate $G_1$, to a read/write control circuit R/W CTR to generate the instruction for reading. Due to data "$Y_1$," set to a $Y_1$ counter $Y_1$ CTR, a signal for setting the beam scanning position to a coordinate $Y_1$ is fed to a digital-to-analog converter DAC. The digital-to-analog converter DAC produces deflection control signals X' and Y'. An ON$(a)$ coordinate signal which is supplied to an ON$(a)$ counter $a$-CTR is fed to the digital-to-analog converter DAC, to set the beam position to $(x_1, y_1)$. Then, as an OFF$(b)$ coordinate value is set to an OFF$(b)$ counter b-CTR, the flip-flop FF is set to render an AND gate $G_3$ conductive, whereby scanning clock signals CLK are fed to the ON$(a)$ counter to stop the operation of the beam blanking driver 6. The ON$(a)$ counter increases the counted value by one after every one clock signal CLK for scanning has been received, and the counter value is supplied to the digital-to-analog converter circuit DAC to deflect the beam in the direction X. When the counted value of the ON$(a)$ counter comes into agreement with the counted value of the OFF$(b)$ counter, a comparator circuit CO produces a pulse which is fed to a flip-flop FF to reset it, whereby the AND gate $G_3$ is rendered non-conductive and the beam blanking driver 6 is actuated. The pulse of the comparator circuit is also fed to the read/write control circuit R/W CTR, thereby to generate the instruction for reading the next data. The pulse is further fed to the $Y_1$ counter to advance the coordinate Y by one. When the scanning does not yet reach the end of the scanning line, the output of the memory LE at the end of the scanning line assumes the "LOW" level, and the AND gate $G_2$ is non-conductive; the content of the $Y_1$ counter is not increased. The above-mentioned operation is repeated thereafter to continuously scan the figure of Fig. 11.

The device shown in Fig. 10A uses the pattern package data consisting of a combination of the data related to the position of start-point coordinate for each of the scanning lines and the data related to the length of the scanning line.

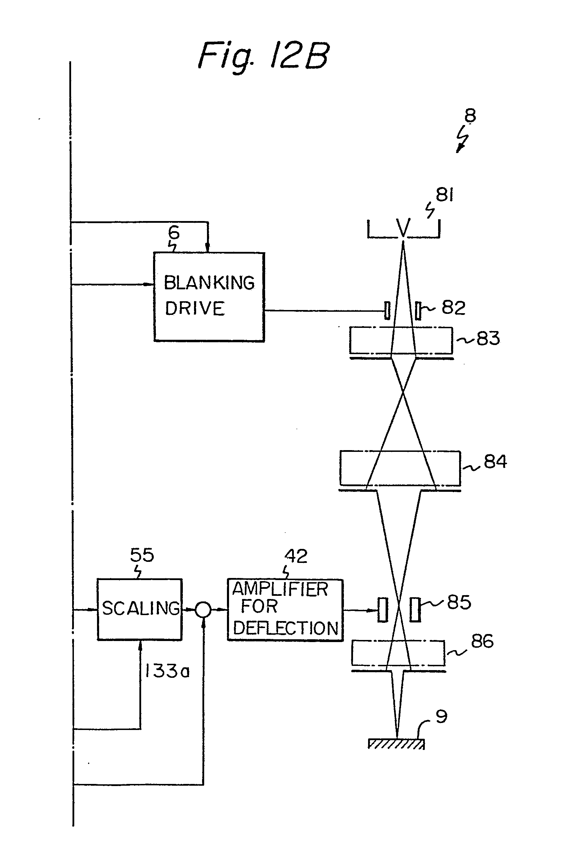

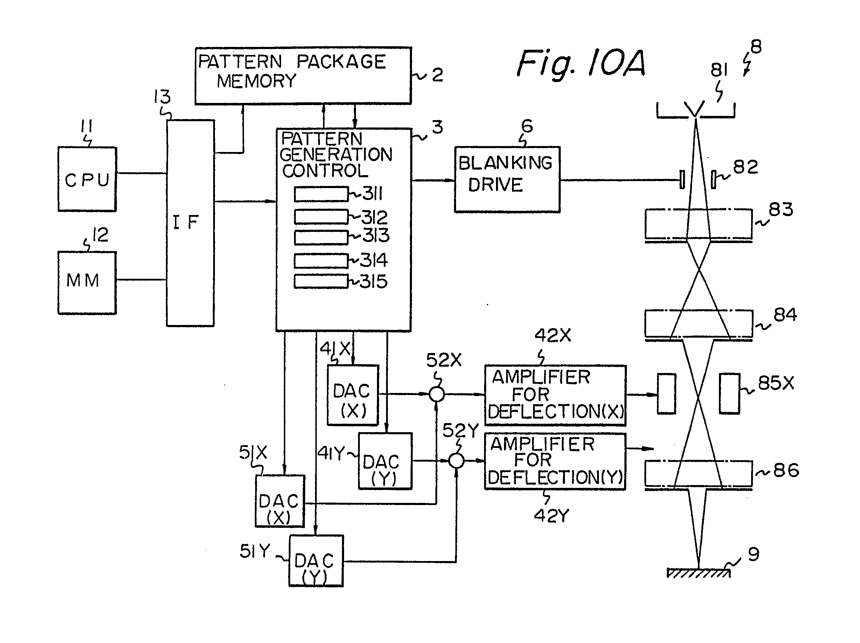

Figs. 12A and 12B illustrate another modified example of the device of Fig. 5.

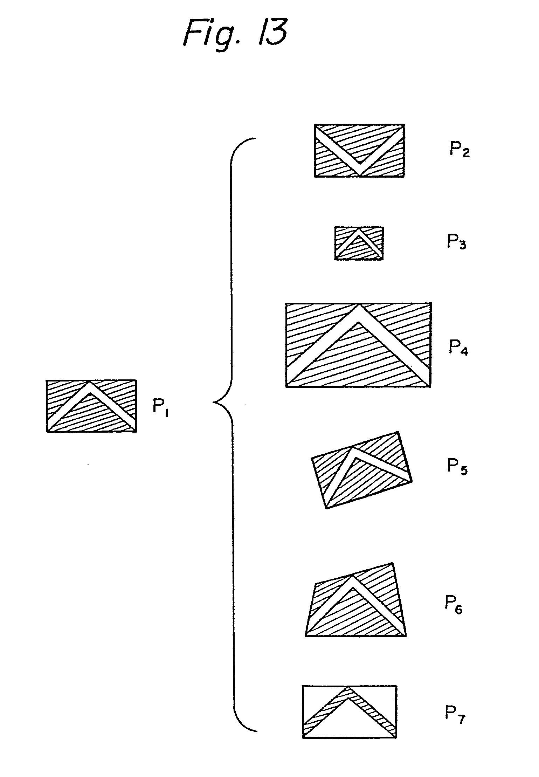

In the device illustrated in Figs. 12A and 12B, a counter circuit 32 is controlled by a signal from a scanning mode instruction register 132 in the interface 13, and the operation of the counter circuit 32 is so switched that the X axis and Y axis of the pattern are scanned in the positive direction or in the reverse direction. Thus, the pattern being exposed can be symmetrically converted relative to the X axis and Y axis ($P_1{\rightarrow}P_2$ in Fig. 13).

In the device illustrated in Figs. 12A and 12B, furthermore, an output 133a of a modification factor instruction register 133 in the interface 13 is supplied to an enlargement reduction (scaling) circuit 55. Further, a modification factor instruction signal is fed to a digital-to-analog converter circuit 53 for modification from the modification factor instruction register 133.

By utilizing the signals from the modification factor instruction register 133, it is possible to obtain a contracted pattern or an enlarged pattern ($P_1{\rightarrow}P_3$, $P_1{\rightarrow}P_4$ in Fig. 13), a rotated pattern ($P_1{\rightarrow}P_5$ in Fig. 13), or a pattern which is formed into a trapezoidal shape ($P_1{\rightarrow}P_6$ in Fig. 13).

In the device of Figs. 12A and 12B, furthermore, a signal from an electron beam blanking mode instruction register 131 in the interface 13 is supplied to the electron beam blanking driver 6, to switch the blanking into a positive polarity or a negative polarity. This makes it possible to invert the black-and-white relation of the exposed pattern ($P_1{\rightarrow}P_7$ in Fig. 13).

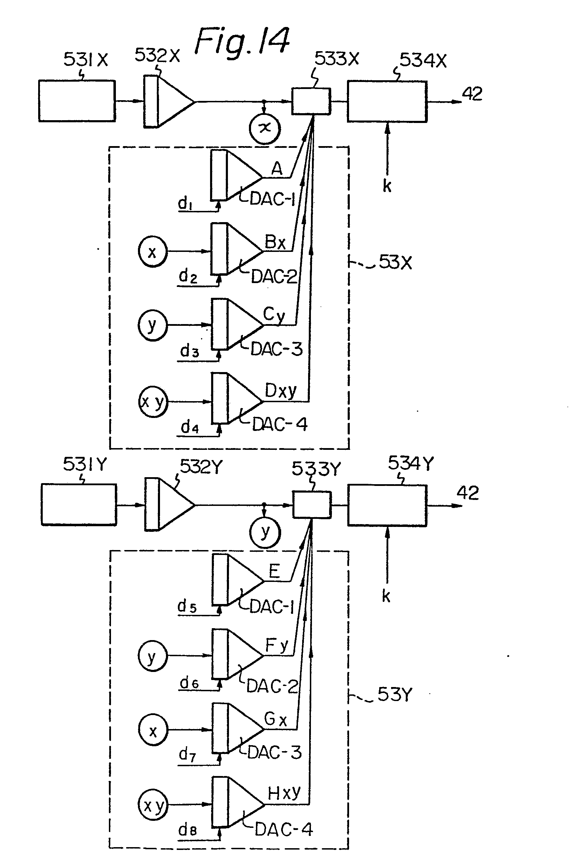

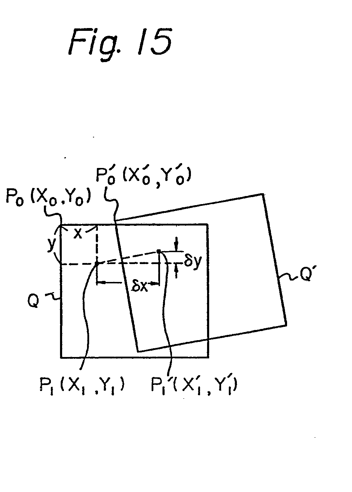

Fig. 14 illustrates a concrete example of the digital-to-analog converter circuit for modification, which used in the device of Fig. 12A, and Fig. 15 illustrates a fundamental pattern and a processed pattern to explain the operation of the circuit shown in Figs. 12A and 12B. Q denotes a rectangular region formed by packaging the fundamental pattern, and Q' denotes a rectangular region which packages a processed pattern which is to be formed as a pattern. Symbols $P_0$, $P_0'$ denote origins in the rectangular regions Q, Q', and $P_1$, $P_1'$ denote corresponding points in the rectangular regions Q, Q'. Coordinates $(X_0, Y_0)$, $(X_0', Y_0')$, $(X_1, Y_1)$ and $(X_1', Y_1')$ are those for the points $P_0$, $P_0'$, $P_1$ and $P_1'$. Symbols x and y denote quantities of displacement from the point $P_0$ to the point $P_1$ in the X and Y directions, and $\delta_x$ and $\delta_y$ denote quantities of modification that will be applied to the data x, y to shift the point of electron beam irradiation to the point $P_1'$. The modification quantities $\delta_x$ and $\delta_y$ can be given by the following equalities,

$$\delta_x = A + Bx + Cy + Dxy$$

$$\delta_y = E + Fy + Gx + Hxy$$

where A and E denote quantities of parallel translation (shifting quantities) in the X and Y directions, C and G denote modification factors for the displacement quantities y and x to attain the rotational motion, B and F denote an enlarging or a contracting factor for modifying the errors associated in the rotation, and D and H denote modification factors for the displacement quantities x and y attain a trapezoidal modification.

Responsive to the instruction of the central processor unit, the modification factor signal is fed from the modification factor instruction register 133 to the digital-to-analog converter circuit 53 for modification, and is added to the output of the digital-to-analog converter circuit 51 for scanning through the adder circuit 54.

Referring to Fig. 14, the digital-to-analog converter circuit for modification consists of a digital-to-analog converter circuit DAC-1 for parallel translation, a digital-to-analog converter circuit DAC-2 for modifying rotational errors, a digital-to-analog converter circuit DAC-3 for rotation, a digital-to-analog converter circuit DAC-4 for trapezoidal deformation, a counter circuit 531X for X axis, a digital-to-analog converter circuit 532X for scanning the X axis, an adder circuit 533X for the X axis, a scaling circuit 534X for the X axis, a counter circuit 531Y for the Y axis, a digital-to-analog converter circuit 532Y for scanning the Y axis, an adder circuit 533Y for the Y axis, and a scaling circuit 534Y for the Y axis. A signal for instructing the scaling factor is denoted by k. Digital signals $d_1$, $d_5$ for instructing the shifting quantities of parallel translation, digital signals $d_3$, $d_7$ for instructing the modification factors of rotation, digital signals $d_2$, $d_6$ for instructing the modification factors for rotational errors, and digital signals $d_4$, $d_8$ for instructing the modification factors for trapezoidal deformation, are supplied to the digital-to-analog converter circuits DAC-1, DAC-2, DAC-3 and DAC-4.

## Claims

1. An exposure system using an electron beam, comprising:

an electron beam blanking means (6, 82);
a scanning electron beam deflector means (42X, Y; 85X, Y);
a pattern generation control circuit (3); and,
a pattern package memory (2);

the pattern generation control circuit (3) storing data on the location and size of a simple surrounding figure (Q) which surrounds a pattern (P) to be irradiated by the electron beam, the pattern package memory (2) storing data giving instructions for when the beam is to be blanked whilst being scanned over the surrounding figure (Q) to generate said pattern (P) to be irradiated, a signal for scanning the entire area of the surrounding figure (Q) based on the location and size data being supplied to the scanning electron beam deflector means (42X, Y; 85X, Y) from the pattern generation control circuit (3) and a signal for blanking the electron beam being supplied to the electron beam blanking means (6, 82) from the pattern package memory (2).

2. An exposure system according to claim 1, wherein a clock control circuit (7) which supplies clock signals to the pattern generation control circuit receives said signal for blanking the electron beam, the clock control circuit (7) producing clock signals of one frequency when the electron beam is irradiating the pattern (P) and producing clock signals of another, higher frequency when the electron beam is blanked so that the electron beam moves more rapidly over the parts of the surrounding figure (Q) that are not to be irradiated.

3. The exposure system according to claim 1 or 2, wherein a first output signal of the pattern generation control circuit (3) is supplied to a digital-to-analog converter (41) for converting the data related to start-points of the surrounding figure (Q), a second output signal is fed to a digital-to-analog converter (51) for the scanning data via a fundamental pattern converter circuit, the output signal of the digital-to-analog converter (41) for the data related to start-points of the surrounding figure (Q) and the output signal of the digital-to-analog converter (51) for the scanning data are added together (52) and are supplied to a deflection amplifier (42), the output signal of the deflection amplifier (42) being applied to a deflection electrode (85) of the scanning electron beam deflector means.

4. An exposure system according to claim 1 or 2, where an input signal of a drive circuit in a scanning electron beam deflector means in the electron beam irradiation device are controlled by conversion signal generator means which converts the mode of the fundamental pattern.

5. An exposure system according to claim 2, wherein input signals of a drive circuit of a blanker in the electron beam irradiation device are controlled by conversion signal generator means which converts the mode of the fundamental pattern.

6. An exposure system according to claim 1, wherein at least the data of the coordinates of the start-point of each of the scanning lines in the surrounding figure (Q) are stored in the pattern package memory (2) as the data related to positions for irradiating the electron beam, and the electron beam is caused to scan only in the pattern which is to be formed as a pattern on the basis of said data of coordinates of the start-point.

## Patentansprüche

1. Bestrahlungssystem, welches einen Elektronenstrahl verwendet, mit:

einer Elektronenstrahl-Austasteinrichtung (6, 82),

einer Ablenkeinrichtung für den Abtastelektronenstrahl (42X, Y; 85Y, Y),
einer Steuerschaltung (3) zur Mustererzeugung, und
einem Musterpaketspeicher (2),

bei welchem die Mustererzeugungs-Steuerschaltung (3) die Daten des Ortes und der Größe einer einfachen umgebenden Figur (Q) speichert, welche ein Muster (P), das mit einem Elektronenstrahl bestrahlt werden soll, umgibt, der Musterpaketspeicher (2) die Daten speichert, welche die Anweisungen dafür geben, wann der Strahl ausgetastet werden soll, während er über die umgebende Figur (Q) streicht, um das genannte Muster (P) zu erzeugen, welches bestrahlt werden soll, ein Signal zur Abtastung der gesamten Fläche der umgebenden Figur (Q), welches auf den Orts- und Größendaten basiert, der Elektronenstrahl-Ablenkungseinrichtung (42X Y; 85X, Y) von der Mustererzeugungs-Steuerschaltung (3) zugeführt wird, und ein Signal zum Austasten des Elektronenstrahls von dem Musterpaket-Speicher (2) der Elektronenstrahl-Austasteinrichtung (6, 82) zugeführt wird.

2. Bestrahlungssystem nach Anspruch 1, bei welchem eine Taktsteuerschaltung (7) welche der Mustererzeugungs-Steuerschaltung Taktsignale zuführt, das genannte Signal zum Austasten des Elektronenstrahls empfängt, die Taktsteuerschaltung (7) Taktsignale von einer Frequenz erzeugt, wenn der Elektronenstrahl das Muster (P) bestrahlt, und Taktsignale einer anderen, höheren Frequenz erzeugt, wenn der Elektronenstrahl ausgetastet werden soll, so daß der Elektronenstrahl sich schneller über die Teile der umgebenden Figur (Q) bewegt, die nicht bestrahlt werden sollen.

3. Bestrahlungssystem nach Anspruch 1 oder 2, bei welchem ein erstes Ausgangssignal der Mustererzeugungs-Steuerschaltung (3) einem Digital/Analog-Konverter (41) zugeführt wird, um die Daten betreffend die Startpunkte der umgebenden Figur (Q) zu konvertieren, und ein zweites Ausgangssignal einem Digital/Analog-Konverter (51) für die Abtastdaten über eine Fundamentalmuster-Konverterschaltung zugeführt wird, das Ausgangssignal des Digital/Analog-Konverters (41) für die Daten bezüglich der Startpunkte der umgebenden Figur (Q) und das Ausgangssignal des Digital/Analog-Konverters (51) für die Abtastdaten miteinander addiert (52) und einem Ablenkungsverstärker (42) zugeführt werden, und das Ausgangssignal des Ablenkungsverstärkers (42) der Ablenkungselektrode (85) der Abtastelektronenstrahl-Ablenkungseinrichtung zugeführt wird.

4. Bestrahlungssystem nach Anspruch 1 oder 2, bei welchem ein Eingangssignal einer Treiberschaltung in einer Abtastelektronenstrahl-Ablenkungseinrichtung in der Elektronenstrahl-Bestrahlungsvorrichtung von einer Konversionssignal-Generatoreinrichtung gesteuert wird, welche den Modus des Fundamentalmusters konvertiert.

5. Bestrahlungssystem nach Anspruch 2, bei welchem Eingangssignale einer Treiberschaltung eines Austasters in der Elektronenstrahl-Bestrahlungsvorrichtung von einem Konversionssignal-Generatoreinrichtung gesteuert wird, welche den Modus des Fundamentalmusters konvertiert.

6. Bestrahlungssystem nach Anspruch 1, bei welchem wenigstens die Daten der Koordinaten der Startpunkte jeder Abtastlinie in der umgebenden Figur (Q) in dem Musterpaketspeicher (2) als Daten, welche die Positionen für die Bestrahlung mit dem Elektronenstrahl betreffen, gespeichert werden, und der Elektronenstrahl veranlaßt wird, lediglich in den Mustern abzutasten, welches als ein Muster auf der Basis der genannten Daten der Koordinaten des Startpunktes zu bilden ist.

**Revendications**

1. Système d'exposition utilisant un faisceau électronique, comprenant

un moyen (6, 82) de suppression de faisceau électronique;
un moyen (42X, Y; 85X, Y) de déviation de faisceau électronique de balayage;
un circuit (3) de commande de production de configurations; et
une mémoire (2) de blocs de configurations;

le circuit (3) de commande de production de configurations emmagasinant des données relatives à l'emplacement et à la taille d'une figure environnante (Q) simple qui entoure une configuration (P) qui doit être irradiée par le faisceau électronique, la mémoire (2) de blocs de configurations emmagasinant des données qui fournissent des instructions sur le moment où le faisceau doit être supprimé tandis qu'il balaye la figure environnante (Q) de façon à produire ladite configuration (P) devant être irradiée, un signal de balayage de l'aire entière de la figure environnante (Q) qui utilise les données d'emplacement et de taille étant délivré au moyen (42X, Y; 85X, Y) de déviation de faisceau électronique de balayage par le circuit (3) de commande de production de configurations, et un signal de suppression de faisceau électronique étant délivré au moyen (6, 82) de supression de faisceau électronique par la mémoire (2) de blocs de configurations.

2. Système d'exposition selon la revendication 1, où un circuit (7) de commande d'horloge qui délivre des signaux d'horloge au circuit de commande de production de configurations reçoit ledit signal de suppression du faisceau électronique, le circuit (7) de commande d'horloge produisant des signaux d'horloge d'une première fréquence lorsque le faisceau électronique irradie la configuration (P) et produisant des signaux d'horloge d'une autre fréquence, plus élevée, lorsque le faisceau électronique est supprimé, si bien que le faisceau électronique se déplace plus rapidement sur les parties de la figure environnante (Q) qui ne doivent pas être irradiées.

3. Système d'exposition selon la revendication 1 ou 2, où un premier signal de sortie du circuit (3) de commande de production de configurations est délivré à un convertisseur numérique-analogique (41) qui convertit les données relatives aux points de départ de la figure environnante (Q), un deuxième signal de sortie est délivré à un convertisseur numérique-analogique (51) associé aux données de balayage via le circuit convertisseur de configuration fondamentale, le signal de sortie du convertisseur numérique-analogique (41) associé aux données des points de départ de la figure environnante (Q) et le signal de sortie du convertisseur numérique-analogique (51) associé aux données de balayage sont ajoutés ensemble (52) et sont délivrés à un amplificateur de déviation (42), le signal de sortie de l'amplificateur de déviation (42) étant appliqué à une électrode de déviation (85) du moyen de déviation de faisceau électronique de balayage.

4. Système d'exposition selon la revendication 1 ou 2, où les signaux d'entrée d'un circuit de commande d'un moyen de déviation de faisceau électronique de balayage du dispositif d'irradiation par faisceau électronique sont commandés par un moyen générateur de signal de conversion qui convertit le mode de la configuration fondamentale.

5. Système d'exposition selon la revendication 2, où les signaux d'entrée d'un circuit de commande d'un moyen de suppression du dispositif d'irradiation par faisceau électronique sont commandés par un moyen générateur de signal de conversion qui convertit le mode de la configuration fondamentale.

6. Système d'exposition selon la revendication 1, où au moins les données des coordonnées du point de départ de chacune des lignes de balayage de la figure environnante (Q) sont emmagasinées dans la mémoire (2) de blocs de configurations comme données associées aux positions d'irradiation par le faisceau électronique, et le faisceau électronique est amené à ne balayer que dans la configuration qui doit être formée comme configuration à partir desdites données de coordonnées du point de départ.

## Fig. 1

## Fig. 2

## Fig. 3

## Fig. 4

Fig. 5

0 029 857

Fig. 6

Fig. 7

Fig. 8

Fig. 9

Fig. 11

Fig. IOB

Fig. IOC

| 0 | 1 | 2 | 3 | 4 | 5 | | | | | | | | | | 15 |
|---|---|---|---|---|---|---|---|---|---|---|---|---|---|---|---|
| Y | a | b | ℓe | | X-DTA / Y-DTA | | | | | | | | | | |

5

## Fig. 12A

Fig. 12

| Fig. 12 A | Fig. 12 B |
|-----------|-----------|

# Fig. 12B

8

81

6

BLANKING
DRIVE

82

83

84

55

42

SCALING

AMPLIFIER
FOR
DEFLECTION

85

86

133a

9

*Fig. IOA*

# Fig. 13

P₂

P₃

P₄

P₁

P₅

P₆

P₇

Fig.14

# Fig. 15